# DEMANDE DE BREVET EUROPEEN

(11) **EP 1 760 763 A2**
(43) Date de publication de la demande: **07.03.2007**
(21) Numéro de dépôt: 06114877.1
(22) Date de dépôt: 01.06.2006
(51) Int. Cl.: H01J 37/32

(54) **Dispositif de contrôle des espèces gazeuses par spectrométrie d'émission optique d'un plasma**

(30) Priorité: 08.06.2005 FR 0551534
(71) Demandeur: ALCATEL, 75008 Paris (FR)
(72) Inventeur: Nomine, Cyrille, 74000 Annecy (FR); Pierrejean, Didier, 74570 Groisy (FR)
(74) Mandataire: Hedarchet, Stéphane

(57) **Abrégé**

Le dispositif de contrôle (1) selon l'invention comprend une excroissance axiale (5) limitée par une paroi périphérique (6) étanche perméable aux champs magnétiques, et raccordée à une enceinte telle qu'une chambre de procédés (11) où sont présentes des espèces gazeuses à contrôler. Un capteur (3) de radiation lumineuse est placé à l'extrémité de l'excroissance axiale d'enceinte (5), et permet le transport de la lumière par une fibre optique (4a) jusqu'à un spectromètre optique (4). Un générateur de plasma (17,18) génère un plasma de contrôle (16) dans l'espace intérieur (8) de l'excroissance axiale d'enceinte (5). Le dispositif comprend un ou plusieurs moyens (7,7a) qui génèrent un champ magnétique (9) ou électrique à proximité du capteur (3) pour former une barrière empêchant la propagation des particules ionisées du plasma de contrôle (16) vers le capteur (3). On évite ainsi l'encrassement du capteur (3) et de l'enceinte.

## Description

La présente invention concerne les dispositifs permettant de contrôler, par spectrométrie d'émission optique, des espèces gazeuses, par exemple contenues dans une enceinte.

On connaît déjà de tels dispositifs de contrôle par spectrométrie d'émission optique, dans lesquels on utilise la radiation lumineuse émise par un plasma présent dans le gaz à analyser, on relève le spectre optique de ladite radiation émise par le plasma, et on procède à une analyse du spectre optique pour en déduire la présence des espèces gazeuses.

Un exemple de détecteur de gaz connu, décrit dans le document US 6,643,014, comprend une paroi étanche définissant une chambre d'excitation en communication directe avec l'atmosphère contenue dans une enceinte dans laquelle on veut détecter les espèces gazeuses présentes. Un plasma est réalisé dans cette chambre d'excitation dérivée, par excitation électromagnétique au moyen d'une antenne d'excitation alimentée par un générateur de puissance. En alternative, l'excitation peut être réalisée par un générateur micro-ondes. Un capteur de radiation comprenant une fibre optique reliée à un spectromètre optique est placé à proximité de la zone de génération du plasma.

De tels dispositifs présentent des inconvénients lorsqu'on les utilise pour contrôler des espèces gazeuses car la formation d'un plasma favorise la génération de dépôts sur les parois de la chambre d'excitation. En effet, le plasma formé favorise les dépôts de particules, non seulement sur la paroi de la chambre d'excitation, mais également sur le capteur de radiation. II en résulte une dégradation progressive de la transmission de lumière vers le spectromètre optique. Les dépôts effectués sur le capteur de radiation constituent un filtre sélectif qui est susceptible de modifier le spectre lumineux transmis, produisant des erreurs dans le contrôle des espèces gazeuses.

Il est alors nécessaire d'interrompre périodiquement le fonctionnement du dispositif de contrôle, pour procéder à un nettoyage de la face intérieure du capteur de radiation. Par exemple, lors d'une utilisation dans des procédés de gravure sous vide, il faut ouvrir l'enceinte à l'atmosphère et nettoyer les parois par un procédé de nettoyage humide, en utilisant des acides ou des solvants. Après nettoyage, on doit pomper à nouveau l'enceinte pendant deux à trois heures pour extraire les gaz et vapeurs de nettoyage, puis on doit réaliser une série de gravures sur des substrats de test, et enfin on peut reprendre le fonctionnement normal des procédés de gravure. On comprend que ces opérations réduisent sensiblement le rendement global des procédés, et augmentent sensiblement le coût de la production.

Par ailleurs d'autres documents proposent diverses solutions pour réduire le risque ou la vitesse de formation des dépôts sur une fenêtre transparente de chambre de procédés permettant de contrôler par spectrométrie d'émission optique les espèces gazeuses contenues dans la chambre.

En particulier, les documents US 6,390,019 et US 6,712,927 décrivent l'utilisation d'aimants permanents ou d'électroaimants placés dans l'atmosphère intérieure de la chambre de procédés, en amont de la fenêtre transparente mais en aval d'un masque ayant une faible ouverture, et générant ainsi un champ magnétique transversal intense qui piège les particules incidentes ionisées provenant du plasma pour les confiner en amont de la fenêtre. Un tel dispositif présente encore divers inconvénients, et notamment les aimants placés à l'intérieur de la chambre de procédés constituent une source de pollution supplémentaire inacceptable. En effet, tôt ou tard, les particules chargées prises au piège dans le champ magnétique peuvent venir se déposer sur les aimants, créant une pollution chimique entre les espèces réactives piégées et la matière constituant les aimants. Ces nouvelles particules ainsi formées sont alors source de contaminations pour le procédé lui-même. Et les aimants eux-mêmes, placés sous vide, dégazent des polluants. De plus, si les dépôts sont trop importants, les aimants doivent être changés ou nettoyés.

Pour éviter cet inconvénient, le document US6,503,364 décrit un dispositif comportant un tube creux dont une extrémité communique par une ouverture avec une chambre de procédé comprenant des moyens pour générer un plasma dont on veut mesurer l'émission optique. A l'autre extrémité du tube creux est installée une fenêtre de mesure en matériau transparent. Un champ magnétique est formé au voisinage de l'ouverture de communication avec la chambre de procédé de manière à empêcher le plasma de pénétrer dans le tube creux. Les molécules adhèrent alors à la paroi de la chambre à proximité de l'ouverture. Le dispositif décrit dans ce document présente l'inconvénient d'entraîner une pollution accrue de la chambre de procédé.

Le but de la présente invention est de proposer un dispositif de contrôle d'un mélange gazeux par spectrométrie d'émission optique qui à la fois permette un fonctionnement de longue durée du dispositif sans nécessiter des nettoyages fréquents du capteur de radiation lumineuse, mais aussi évite toute génération de pollution dans l'enceinte. Ce qui dans le cas où l'enceinte est une chambre de procédé, est susceptible de perturber les procédés.

Le dispositif de contrôle selon l'invention doit être totalement propre et transparent pour les procédés dans lesquels il est adapté.

L'invention a pour objet un dispositif de contrôle, pour contrôler par spectrométrie d'émission optique des espèces gazeuses contenues dans une enceinte, comprenant
- une excroissance axiale, reliée à ladite enceinte par une extrémité ouverte, limitée par une paroi périphérique étanche perméable aux champs magnétiques et aux ondes radiofréquence,
- des moyens de génération d'un plasma de contrôle, dont la lumière va être analysée, dans l'espace intérieur de l'excroissance axiale,
- au moins un capteur de radiation lumineuse émise par le plasma de contrôle, disposé sur la paroi de l'excroissance axiale,
- des moyens d'analyse de spectre d'émission placés à l'extérieur de la paroi étanche et recevant la lumière émise par le plasma de contrôle et recueillie par le capteur,
- un moyen de génération, dans l'espace intérieur de l'excroissance axiale, d'un champ orienté transversalement par rapport à la direction I-I de propagation du flux lumineux vers le capteur et assurant une déviation du flux de particules ionisées et d'électrons du plasma de contrôle à l'écart du capteur, ledit moyen étant placé à proximité et à l'extérieur de la paroi périphérique étanche d'excroissance axiale, de manière à générer un champ à l'extrémité de l'excroissance axiale opposée à l'extrémité ouverte et à proximité immédiate du capteur.

Le capteur de la radiation lumineuse émise par le plasma de contrôle peut comprendre par exemple une portion de la paroi de l'excroissance axiale présentant une transparence à la lumière émise par un plasma, en particulier la portion de la paroi fermant l'une des extrémités de l'excroissance axiale. Grâce à la disposition du capteur à l'extrémité de l'excroissance axiale opposée à l'ouverture vers l'enceinte, le moyen de génération d'un champ peut être placé à l'extérieur de excroissance axiale tout en étant à proximité de la zone de l'espace intérieure de l'excroissance axiale qui se trouve en amont du capteur dans le sens de progression de la lumière et des particules ionisées provenant du plasma. De la sorte, le moyen de génération peut créer un champ en amont du capteur, pour assurer la déviation du flux de particules ionisées et d'électrons du plasma et éviter ainsi que des particules ionisées atteignent le capteur et s'y déposent. Une surface suffisante de paroi de l'excroissance axiale doit être laissée entre le champ et l'ouverture de communication avec l'enceinte de telle sorte que les particules ionisées se déposent sur la paroi de l'excroissance axiale et n'aillent pas polluer l'enceinte.

Des moyens de génération de plasma sont prévus pour ioniser les espèces gazeuses à contrôler dans l'espace intérieur du tube. Pour générer le plasma, on peut prévoir une antenne extérieure d'excitation alimentée par un générateur haute fréquence pour produire un champ électromagnétique haute fréquence d'excitation. Le champ traverse la paroi périphérique d'excroissance axiale d'enceinte elle-même réalisée de préférence en un matériau non conducteur de l'électricité tel que le quartz, le verre, le BK7, le saphir, une céramique (ZrO2, Cr2O3, ...).

Selon une première forme d'éxécution de l'invention, le moyen de génération (7) est un moyen de génération d'un champ magnétique. Les électrons du plasma, qui provoquent l'ionisation des particules, sont piégés par le champ magnétique et ne peuvent pas passer la barrière magnétique constituée par le champ magnétique transversal. Ils ne peuvent donc pas ioniser des particules au-delà de la barrière magnétique.

La paroi périphérique de l'excroissance axiale est en un matériau présentant des propriétés satisfaisantes d'amagnétisme pour être perméable aux champs magnétiques.

Selon un mode de réalisation avantageux, on prévoit deux aimants disposés respectivement de part et d'autre de l'excroissance axiale d'enceinte et s'attirant l'un l'autre. Ainsi, les champs magnétiques créés par l'un et l'autre des aimants s'ajoutent dans la zone intérieure de l'excroissance axiale d'enceinte en amont du capteur.

Dans ce mode de réalisation, les aimants peuvent être plaqués contre la face externe de la paroi périphérique d'excroissance axiale d'enceinte, retenus en place par leur propre force d'attraction magnétique mutuelle.

De la sorte, les aimants sont aisément démontables, par exemple pour le démontage de la partie d'enceinte constituant l'excroissance axiale d'enceinte, par exemple lors d'un nettoyage.

Une amélioration peut être obtenue en prévoyant que les aimants sont enveloppés extérieurement par une pièce extérieure annulaire en matière amagnétique, pour assurer la fonction de maintien mécanique, ou par une pièce extérieure annulaire en matériau magnétique pour assurer la double fonction de

maintien mécanique et de blindage magnétique en refermant les lignes de champ magnétique autour de l'excroissance axiale d'enceinte.

Le ou les aimants peuvent être des aimants permanents. Alternativement le ou les aimants peuvent être des électroaimants.

Selon une deuxième forme d'éxécution de l'invention, le moyen de génération est un moyen de génération d'un champ électrique.

L'excroissance axiale est réalisée de préférence, mais non exclusivement, sous forme d'un tube axial, destiné à être rapporté et mis en communication avec une enceinte où sont présentes les espèces gazeuses à contrôler, le tube étant fermé à une extrémité par une portion de paroi et étant ouvert à l'extrémité opposée pour le raccordement à l'enceinte, et des moyens de génération de plasma étant prévus pour ioniser les espèces gazeuses à contrôler dans l'espace intérieur du tube.

Ce dispositif est utilisable pour analyser le mélange gazeux contenu dans une enceinte qui peut être notamment une chambre de procédés, que le procédé mis en oeuvre le soit avec ou sans plasma, ou une canalisation, mais aussi tout autre volume dont on souhaite analyser l'atmosphère.

L'ouverture (5a) vers l'excroissance axiale (5) est de préférence réalisée dans la paroi de ladite enceinte (11, 19).

L'invention a aussi pour objet une installation de traitement d'un substrat semi-conducteur comprenant le dispositif de contrôle précédemment décrit, communiquant avec une chambre de procédés, le dispositif de contrôle étant ainsi adapté pour contrôler les espèces gazeuses à l'intérieur même de la chambre de procédés.

L'invention a encore pour objet une installation de traitement d'un substrat semi-conducteur comprenant le dispositif de contrôle précédemment décrit, communiquant avec une ligne de vide (19).

D'autres objets, caractéristiques et avantages de la présente invention ressortiront de la description suivante de modes de réalisation particuliers, faite en relation avec les figures jointes, parmi lesquelles
- la figure 1 est une vue schématique illustrant un dispositif de contrôle selon un premier mode de réalisation, sous forme d'un dispositif indépendant raccordé à une chambre de procédés,
- la figure 2 illustre schématiquement le dispositif de contrôle selon le mode de réalisation de la figure 1, adapté pour contrôler les gaz dans une ligne de vide elle-même raccordée à une chambre de procédés,
- la figure 3 est une vue de côté schématique partielle d'un dispositif de contrôle selon l'invention, en coupe longitudinale à plus grande échelle,
- la figure 4 est une coupe transversale selon le plan A-A de la figure 3,
- la figure 5 est une vue de dessus schématique partielle en coupe à plus grande échelle du dispositif de la figure **4**, illustrant la déviation des particules ionisées,
- la figure 6 illustre le spectre de l'air obtenu au moyen d'un dispositif selon l'art antérieur, et
- la figure 7 illustre le spectre de l'air obtenu au moyen du dispositif selon l'invention.

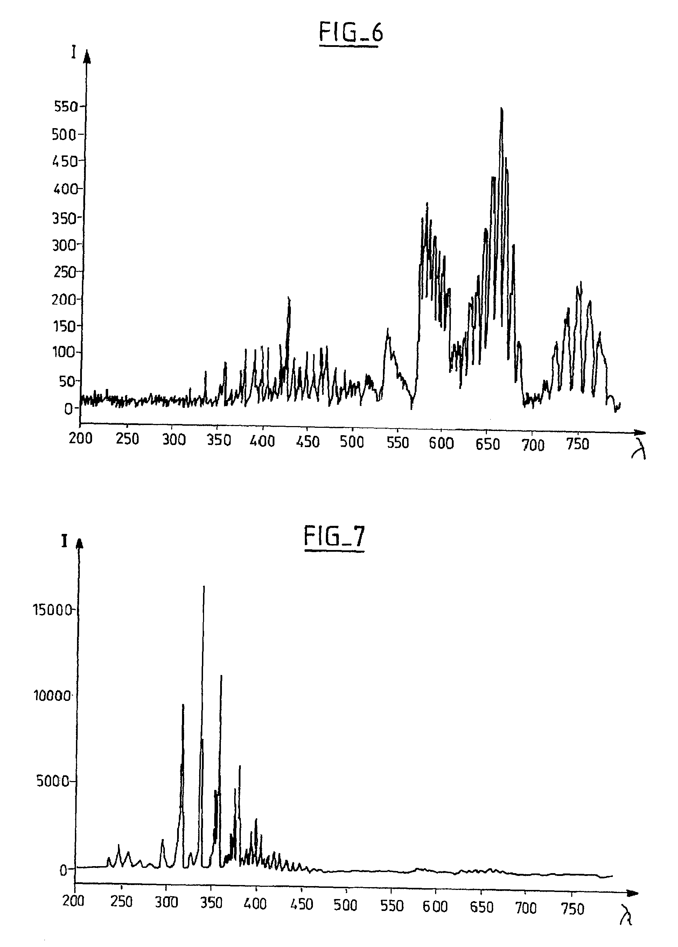

Sur les figures 6 et 7, l'intensité des raies en unités arbitraires (u.a.) est donnée en ordonnée, et en abscisse la longueur d'onde en nanomètre (nm). Les spectres des figures 6 et 7 ont été obtenus avec le même réglage du spectromètre optique.

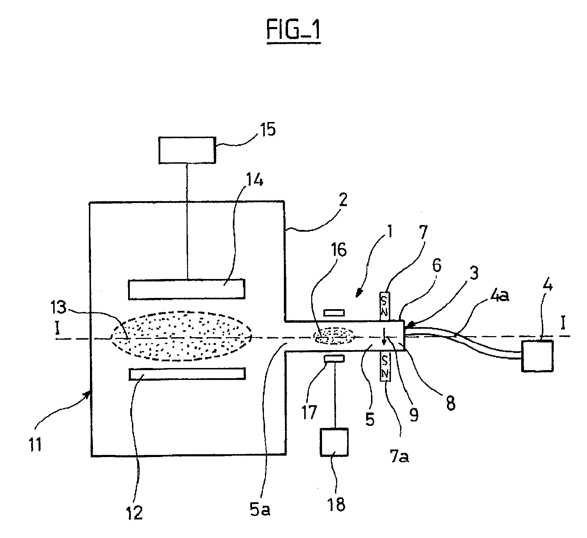

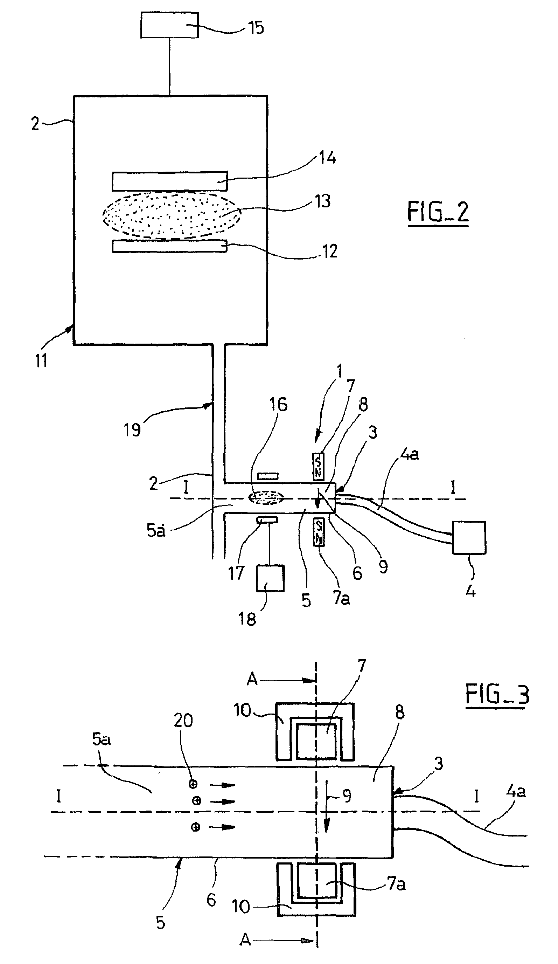

Dans les modes de réalisation illustrés sur les figures 1 et 2, un dispositif de contrôle **1** selon l'invention est destiné à contrôler, par spectrométrie d'émission optique, des espèces gazeuses contenues dans une enceinte isolée de l'extérieur par une paroi **2** étanche aux gaz. La paroi **2** comporte au moins un capteur **3** comprenant une portion de la paroi **6** étanche aux gaz mais transparente à la lumière émise par un plasma.

Des moyens d'analyse de spectre d'émission **4** sont placés à l'extérieur de la paroi **2** étanche, et reçoivent la lumière émise par un plasma et transmise par le capteur **3.** La radiation lumineuse traverse successivement la portion d'extrémité de la paroi **6,** puis un moyen de transmission tel qu'une fibre optique **4a,** la capteur **3** comprenant ici la portion d'extrémité de la paroi **6** transparente à la lumière et la fibre optique **4a.**

Dans ces modes de réalisation, le capteur **3** est placé à l'extrémité d'une excroissance axiale **5** limitée par une paroi périphérique **6** étanche aux gaz et perméable aux champs magnétiques, se développant le long de l'axe I-I à l'écart de la partie principale de paroi étanche **2** de l'enceinte.

La paroi périphérique **6** de l'excroissance axiale **5** peut avantageusement être en un matériau présentant des propriétés satisfaisantes d'amagnétisme pour être perméable aux champs magnétiques, mais également aux ondes radiofréquences. La paroi **6** est de préférence en un matériau non-conducteur de l'électricité tel que le quartz, le verre, le BK7, le saphir, ou une céramique (ZrO2, Cr2O3, ...) par exemple.

L'excroissance axiale **5** est de forme tubulaire, mais peut prendre également toute autre forme. Dans le cas représenté sur les figures, le tube **5** est fermé à une première extrémité par la portion de paroi **6** comprise dans le capteur **3**, et il est ouvert à la seconde extrémité **5**a pour le passage des gaz à contrôler.

Le dispositif de contrôle **1** comprend en outre, placé à proximité et à l'extérieur de la paroi périphérique **6** étanche d'excroissance axiale **5,** au moins un moyen de génération d'un champ qui peut être magnétique ou électrique tel qu'un aimant **7** qui génère, dans l'espace intérieur **8** de l'excroissance axiale **5,** un champ magnétique **9** orienté transversalement par rapport à la direction de propagation du flux lumineux vers le capteur **3.** La direction de propagation du flux lumineux utile est illustrée par l'axe I-I longitudinal de l'excroissance axiale **5.** Le champ magnétique **9** transversal assure une déviation du flux de particules ionisées du plasma en les maintenant à l'écart du capteur **3.**

Dans la réalisation illustrée sur les figures 1 et 2, le dispositif de contrôle **1** comprend deux aimants **7** et **7a** pour générer, dans l'espace intérieur 8 de l'excroissance axiale **5,** un champ magnétique **9** transversal qui dévie les particules ionisées à l'écart du capteur **3**. Les aimants **7** et **7a** sont disposés respectivement de part et d'autre de l'excroissance axiale **5,** et s'attirent l'un l'autre.

Par exemple, les aimants **7** et **7a** peuvent être simplement plaqués contre la face externe de la paroi périphérique **6** d'excroissance axiale **5,** retenus en place par leur propre force d'attraction magnétique mutuelle.

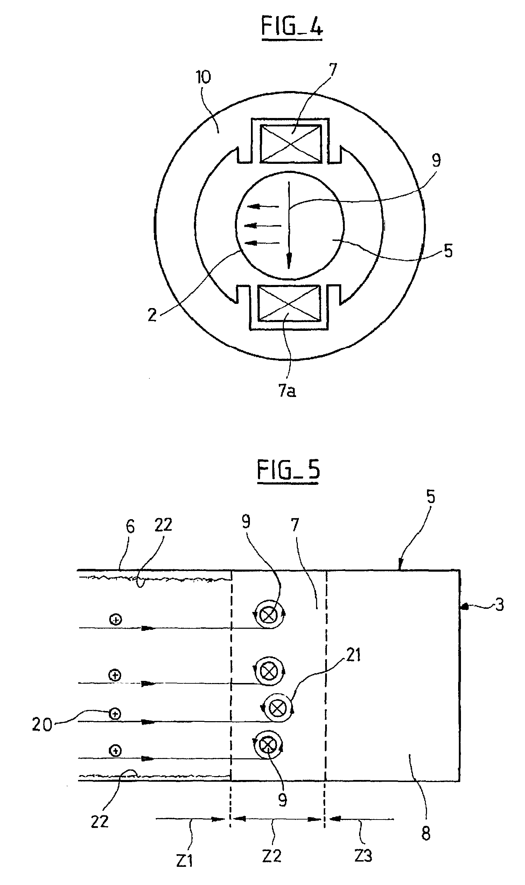

Pour concentrer le champ magnétique **9** dans l'espace intérieur **8** de l'excroissance axiale **5,** favorisant la déviation des particules chargées à l'écart du capteur 3, on peut avantageusement prévoir, comme illustré sur les figures 3 et 4, que les aimants **7** et **7a** soient enveloppés extérieurement par une pièce extérieure annulaire **10** en matériau magnétique, formant une armature assurant la fonction de blindage magnétique et refermant les lignes de champ magnétique autour de l'excroissance axiale **5.**

On considère maintenant plus particulièrement le mode de réalisation illustré sur la figure 1.

Dans ce cas, le dispositif de contrôle **1** est rapporté sur une chambre de procédés **11** dans laquelle se déroulent des procédés de traitement d'un substrat **12.** La chambre de procédés **11** contient généralement des gaz de procédés à faible pression, dont on veut contrôler la présence et la concentration.

Le dispositif de contrôle **1** selon l'invention, sous forme d'un tube axial amovible, est rapporté et mis en communication avec l'enceinte constituée par la chambre de procédés **11** où sont présentes les espèces gazeuses à contrôler. Le dispositif de contrôle **1** comprend lui-même des moyens pour générer un plasma **16** de contrôle dont la lumière va être analysée par les moyens d'analyse de spectre d'émission **4.** Le dispositif de contrôle **1** comprend ainsi une antenne d'excitation **17** alimentée par un générateur de puissance **18,** qui excite les particules gazeuses chargées présentes dans l'espace intérieur **8** de l'excroissance axiale d'enceinte **5** pour créer un plasma **16** de contrôle. La lumière émise par le plasma **16** de contrôle se propage selon l'axe I-I jusqu'au capteur **3** puis, via la fibre optique **4a,** jusqu'aux moyens d'analyse de spectre d'émission **4.**

On considère maintenant le dispositif illustré sur la figure 2.

On y retrouve le dispositif de contrôle **1** du mode de réalisation de la figure 1, qui est un dispositif rapporté sur une enceinte constituée par une ligne de vide **19** elle-même raccordée à une chambre de procédés **11.**

On retrouve les moyens pour générer un plasma **16** de contrôle dans l'espace intérieur **8** de l'excroissance axiale **5,** à savoir une antenne d'excitation **17** et un générateur de puissance **18.**

On retrouve les autres moyens constituant le dispositif de contrôle **1,** tel qu'illustré précédemment sur la figure 1, et ces mêmes moyens sont repérés par les mêmes références numériques.

Sur cette figure 2, le dispositif de contrôle **1** est ainsi adapté pour contrôler les espèces gazeuses contenues dans la ligne de vide **19.**

On considère maintenant les figures 3 et 4, qui illustrent un mode de réalisation dans lequel les aimants **7** et **7a** sont tenus par une pièce extérieure annulaire **10.**

Selon une première réalisation, la pièce extérieure annulaire **10** est réalisée en matériau amagnétique, par exemple en aluminium ou en matière plastique, pour assurer la fonction de maintien mécanique des aimants **7** et **7a.**

Selon un second mode de réalisation, la pièce extérieure annulaire **10** peut être réalisée en matériau magnétique, pour assurer la double fonction de maintien mécanique et de blindage magnétique en refermant les lignes de champ magnétique autour de l'excroissance axiale **5.**

Dans tous les cas, le ou les aimants **7** et **7a** peuvent être des aimants permanents.

En alternative, on peut prévoir que le ou les aimants **7** et **7a** sont des électroaimants, alimentés en énergie électrique par une source d'énergie électrique, non illustrée sur les figures.

Dans les modes de réalisation illustrés sur les figures 1 et 2, le dispositif de contrôle **1** est un dispositif rapporté muni de moyens de génération d'un plasma **16** de contrôle comprenant l'antenne d'excitation **17** et le générateur de puissance **18.** Il faut aussi que la paroi périphérique **6** soit en un matériau non-conducteur de l'électricité, laissant passer les ondes électromagnétiques d'excitation du plasma générées par l'antenne d'excitation **17** et le générateur de puissance **18.** Dans ce cas, on peut avantageusement prévoir que l'excroissance axiale **5** est sous forme d'un tube dont la paroi périphérique **6** est en matériau non-conducteur de l'électricité tel que le quartz, le verre, le BK7, ou le saphir, par exemple.

Le fonctionnement du dispositif de contrôle **1** selon l'invention est le suivant.

Les moyens d'analyse de spectre d'émission **4,** tels qu'un spectromètre optique, reçoivent, par une fibre optique **4a** ou tout autre moyen de transmission approprié, la lumière émise par un plasma **16** de contrôle recueillie par le capteur **3,** contenant des espèces gazeuses à analyser. La lumière se propage le long de l'excroissance axiale **5,** atteint la paroi 6 au niveau du capteur **3** et se propage par la fibre optique **4a** jusqu'au spectromètre optique **4.** Simultanément, la présence d'un plasma **16** implique la présence de particules ionisées susceptibles de créer des dépôts sur le capteur **3,** conduisant à l'obscurcir progressivement en dénaturant le spectre optique mesuré.

Sur la figure 6, on a illustré le spectre optique d'émission d'un plasma dans l'air, mesuré au moyen du capteur d'un dispositif selon l'art antérieur, comme par exemple celui décrit dans le document US-6,643,014 incorporé ici par référence, qui porte un dépôt de particules ionisées. On voit que le dépôt déforme sensiblement le spectre. Les raies UV sont extrêmement faibles car elles sont complètement absorbées par le dépôt qui s'est formé à l'intérieur du tube, sur la face interne du capteur (intensité maximum 550 u.a.). Au pire le capteur peut devenir complètement opaque et empêcher tout fonctionnement correct du système de détection.

Sur la figure 7, on a illustré le spectre optique d'émission d'un plasma dans l'air, mesuré au moyen d'un capteur comprenant une portion transparente de la paroi d'un dispositif selon l'invention propre et dépourvue de dépôt de particules ionisées. Les raies UV ressortent bien car elles ne rencontrent aucun obstacle (intensité maximum 16 000 u.a.). Le dispositif selon l'invention empêche les particules ionisées d'atteindre le capteur, gardant celui-ci parfaitement propre et permettant une sensibilité des mesures qui reste optimale. La sensibilité de détection est environ 100 fois meilleure que dans le cas de la figure 6.

En considérant les figures 3 à 5, on a illustré des particules ionisées **20,** présentes dans l'espace intérieur **8** de l'excroissance axiale **5.** Les particules se déplacent en tous sens, et certaines particules ionisées **20** tendent à se déplacer axialement en direction du capteur **3** dans la zone **Z1** en amont des aimants **7** et **7a**. Le champ magnétique 9 généré entre les aimants 7 (placé derrière l'excroissance axiale **5** et représenté par une ligne de tirets) et **7a,** en amont du capteur **3,** produit sur ces particules ionisées **20** une force de déviation qui tend à leur imprimer un mouvement circulaire **21** s'enroulant autour des lignes du champ magnétique **9** transversal, comme symbolisé de manière schématique dans la zone **Z2** de la figure 5.

En pratique, les aimants **7** et **7a** réalisent une barrière magnétique qui empêche la propagation des particules ionisées **20** et des électrons dans la zone **Z3,** au-delà de la zone **Z2** occupée par le champ magnétique **9.** Ainsi, les dépôts éventuels **22** de particules s'effectuent sur la paroi périphérique **6** en amont de la zone **Z2** occupée par les aimants **7** et **7a.** On comprend que la partie du dispositif situé en amont de la zone **Z2** doit présenter une surface suffisante pour permettre aux particules de s'y déposer, sans risquer un dépôt au-delà de l'ouverture **5a** du dispositif qui serait susceptible d'aller polluer l'enceinte. Par conséquent le champ magnétique doit être généré au plus loin de l'extrémité ouverte **5a** du dispositif **1,** et à proximité immédiate de son extrémité fermée où est situé le capteur **3.** Ainsi les particules ionisées **20** n'atteignent pas le capteur **3,** et on conserve ainsi la mesure correcte du spectre optique d'émission comme illustré sur la figure 7.

Selon l'invention, l'enceinte contenant les gaz à analyser, ainsi que l'excroissance axiale **5,** ne contiennent aucun élément étranger tel que des antennes, des aimants ou autres, susceptibles de créer une pollution des gaz contenus à l'intérieur de l'enceinte. Les gaz contenus à l'intérieur de l'enceinte sont en contact seulement avec les parois **2** ou **6,** de sorte que le dispositif de contrôle **1** selon l'invention est parfaitement neutre vis-à-vis des procédés se déroulant dans l'enceinte.

Dans les modes de réalisation des figures 1 et 2, le dispositif de contrôle **1** peut aisément être démonté en enlevant les aimants **7** et **7a,** puis le tube constituant l'excroissance axiale **5,** pour un nettoyage, le cas échéant.

Grâce à la présence des aimants **7** et **7a,** le capteur **3** n'est pas affectée par la présence d'un plasma intérieur **16,** et il n'est plus nécessaire de procéder à son nettoyage fréquent.

La présente invention n'est pas limitée aux modes de réalisation qui ont été explicitement décrits, mais elle en inclut les diverses variantes et généralisations qui sont à la portée de l'homme du métier.

## Revendications

1. Dispositif de contrôle (1) pour contrôler par spectrométrie d'émission optique des espèces gazeuses contenues dans une enceinte comprenant
- une excroissance axiale (5), reliée à ladite enceinte par une extrémité ouverte (5a), limitée par une paroi périphérique (6) étanche perméable aux champs magnétiques et aux ondes radiofréquence,
- des moyens (17, 18) de génération d'un plasma (16) de contrôle, dont la lumière va être analysée, dans l'espace intérieur (8) de l'excroissance axiale (5),
- au moins un capteur (3) de radiation lumineuse émise par le plasma (16) de contrôle, sur la paroi (6) de l'excroissance axiale (5),
- des moyens d'analyse de spectre d'émission (4) placés à l'extérieur de la paroi (6) étanche et recevant la lumière émise par le plasma (16) de contrôle et recueillie par le capteur (3),
**caractérisé en ce qu'**il comprend en outre un moyen (7) de génération, dans l'espace intérieur (8) de l'excroissance axiale (5), d'un champ (9) orienté transversalement par rapport à la direction I-I de propagation du flux lumineux vers le capteur (3) et assurant une déviation du flux de particules ionisées (20) et d'électrons du plasma (16) de contrôle à l'écart du capteur (3), ledit moyen (7) étant placé à proximité et à l'extérieur de la paroi périphérique (6) étanche d'excroissance axiale (5), de manière à générer un champ (9) à l'extrémité de l'excroissance axiale (5) opposée à l'extrémité ouverte (5a) et à proximité immédiate du capteur (3).

2. Dispositif selon la revendication 1, dans lequel le capteur (3) comprend une portion de la paroi (6) de l'excroissance axiale (5) présentant une transparence à la lumière émise par le plasma de contrôle.

3. Dispositif selon la revendication 2, dans lequel le capteur (3) comprend la portion de paroi (6) fermant l'une des extrémités de l'excroissance axiale.

4. Dispositif selon l'une des revendication 1 à 3, dans lequel la paroi périphérique (6) d'excroissance axiale d'enceinte (5) est en matériau non-conducteur de l'électricité.

5. Dispositif selon la revendication 4, dans lequel le matériau de la paroi périphérique (6) d'excroissance axiale d'enceinte (5) est choisi parmi quartz, le verre, le BK7, et le saphir.

6. Dispositif selon l'une des revendications précédentes, dans lequel le moyen de génération (7) est un moyen de génération d'un champ magnétique.

7. Dispositif selon la revendication 6, dans lequel la paroi périphérique (6) de l'excroissance axiale (5) est en un matériau présentant des propriétés satisfaisantes d'amagnétisme pour être perméable aux champs magnétiques.

8. Dispositif selon l'une des revendications 6 et 7, comprenant deux aimants (7, 7a) disposés respectivement de part et d'autre de l'excroissance axiale (5) et s'attirant l'un l'autre.

9. Dispositif selon la revendication 8, dans lequel les aimants (7, 7a) sont plaqués contre la face externe de la paroi périphérique (6) d'excroissance axiale (5), retenus en place par leur propre force d'attraction magnétique mutuelle.

10. Dispositif selon l'une des revendications 6 à 9, dans lequel les aimants (7, 7a) sont enveloppés extérieurement par une pièce extérieure annulaire (10), réalisée en matériau amagnétique pour assurer la fonction de maintien mécanique, ou réalisée en matériau magnétique pour assurer la double fonction de maintien mécanique et de blindage magnétique en refermant les lignes de champ magnétique autour de l'excroissance axiale (5).

11. Dispositif selon l'une des revendications 6 à 10, dans lequel le ou les aimants (7, 7a) sont des aimants permanents.

12. Dispositif selon l'une des revendications 6 à 10, dans lequel le ou les aimants (7, 7a) sont des électroaimants.

13. Dispositif selon l'une des revendications 1 à 3, dans lequel le moyen de génération (7) est un moyen de génération d'un champ électrique.

14. Dispositif selon l'une des revendications précédentes, dans lequel l'excroissance axiale d'enceinte (5) est réalisée sous forme d'un tube axial, destiné à être rapporté et mis en communication avec une enceinte (11, 19) où sont présentes les espèces gazeuses à contrôler, le tube étant fermé à une extrémité par une portion de paroi (6) et étant ouvert à l'extrémité opposée (5a) pour le raccordement à l'enceinte (11, 19), et des moyens de génération de plasma (17, 18) étant prévus pour ioniser les espèces gazeuses à contrôler dans l'espace intérieur (8) du tube.

15. Dispositif selon l'une des revendications précédentes, dans lequel l'ouverture (5a) vers l'excroissance axiale (5) est réalisée dans la paroi de ladite enceinte (11, 19).

16. installation de traitement d'un substrat semi-conducteur comprenant un dispositif (1) de contrôle selon l'une des revendications 1 à 13, communiquant avec une chambre de procédés (11), le dispositif de contrôle (1) étant ainsi adapté pour contrôler les espèces gazeuses à l'intérieur même de la chambre de procédés (11).

17. installation de traitement d'un substrat semi-conducteur comprenant un dispositif (1) de contrôle selon l'une des revendications 1 à 13, communiquant avec une ligne de vide (19).
